# EUROPEAN PATENT APPLICATION

(11) **EP 1 359 793 A1**
(43) Date of publication of application: **05.11.2003**
(21) Application number: 03075418.8
(22) Date of filing: 13.02.2003
(51) Int. Cl.: H05K 5/02, H02B 1/30

(54) **Safety devices introduced in cabinet to house telecommunication equipment**

(30) Priority: 30.04.2002 BR 8200933 U
(71) Applicant: Nilko Metalurgia, Ltda., Piraquara-Parana (BR)
(72) Inventor: Huscher, Fraimundo, Curitiva, PR (BR)
(74) Representative: Manresa Val, Manuel

(57) **Abstract**

SAFETY DEVICES INTRODUCED IN CABINET TO HOUSE TELECOMMUNICATION EQUIPMENT, the present patent is described as safety devices introduced in cabinets to house telecommunication equipment which, in accordance with the characteristics thereof, possesses as a principle the introduction of a proper and specific set of devices and improvements in the safety area in general on the structure of the cabinet (1), in order to optimize and render safer the utilization and safekeeping thereof against vandalism and thefts. The present safety devices are formed by a set of devices and improvements in the safety area incorporating and improving various proper and specific components arranged in the basic structure of the cabinet (1), in order to incorporate therein a complete and fully safe assembly that guarantee its integrity and that of the equipment housed in it against vandalism, thefts, robberies, non authorized access and the like.

## Description

The present patent relates to cabinets for telecommunications in general, more specifically to safety devices introduced in cabinets to house telecommunication equipment which, according to the characteristics thereof, possesses as a basic principle the introduction of a proper and specific set of devices and improvements in the safety area in general on the structure of cabinets to house telecommunication equipment, in order to provide a safe and reliable utilization and protection of the latter against vandalism and thefts in general, being based on a robust, safe and lasting set of devices. With a specific design and shape, easily accessible for a better adaptation, safety for the users, practical handling, functionality and accessible cost and due to its characteristics and dimensions, is easily adaptable to the cabinet structure, regardless of the place and the type of telecommunication equipment.

The patent in question is characterized in that it aggregates components and processes in a differentiated concept to meet the various requirements the nature of its use demands. Such concept provides the cabinet to house telecommunication equipment great efficiency, functionality, strength, durability and safety due to its excellent technical qualities, thereby providing advantages and improvements to the cabinet as a whole, the general characteristics of which differ from the other shapes and models known in the current state of the art.

The present patent consists in the utilization of modern, versatile, efficient and functional safety devices introduced in a cabinet to house telecommunication equipment, formed by an assembly of properly incorporated mechanical and safety solutions comprising and improving various proper and specific components with exclusive design, made of metallic material, optimum finish details and proprietary characteristics, perfectly arranged (fitted and attached) to the basis structure thereof such as a micro-switch type key on the door, a differentiated design on the door rod assembly, one-piece hinges on the doors, a micro-cast type lock on the door, vertical profiles for the door closing frames provided with protective borders, T-profiles on the vertical columns, protection devices for the outer anchor shoe bolts near the base, devices for housing the door rod tips, a set of rivets on the doors and a hood with an additional perforated rim, so as to form in the cabinet structure with double sheets of aluminum or similar material and plate/plate sandwich-type closing system, and double wall with spacers, a complete and fully safe assembly with the function of ensuring its integrity and that of the pieces of equipment housed thereof against vandalism, thefts, robberies, non authorized access and the like installed in public ways or the like.

Through the present safety devices introduced in the cabinet to house telecommunication equipment, destined to improve and guarantee their protection against vandalism, thefts, robberies, non authorized access and the like, last-generation technological solutions are incorporated thereto, thereby providing an excellent safety, strength, durability and quality level to the entire safekeeping and usage process of the cabinets to house telecommunication equipment.

The present invention is based on the utilization of safety devices comprising components and processes in a differentiated concept, thereby allowing to solve some of the main inconveniences of the other shapes and models of cabinets to house telecommunication equipment in general, as known in the current state of the art, which are located in a work range wherein there is no proper and safe protection against undue violation and vandalism, thefts, robberies, non authorized access and the like and whose shapes and/or products are obsolete and handcrafted locally based in adaptations, which causes fragility and difficult maintenance, low strength and durability, or else they have a large structure, which means high costs, difficult and slow installation and the need of high skilled labor.

The objects, advantages and other important characteristics of the patent in question can be more easily understood when read jointly with the appended drawings, wherein:

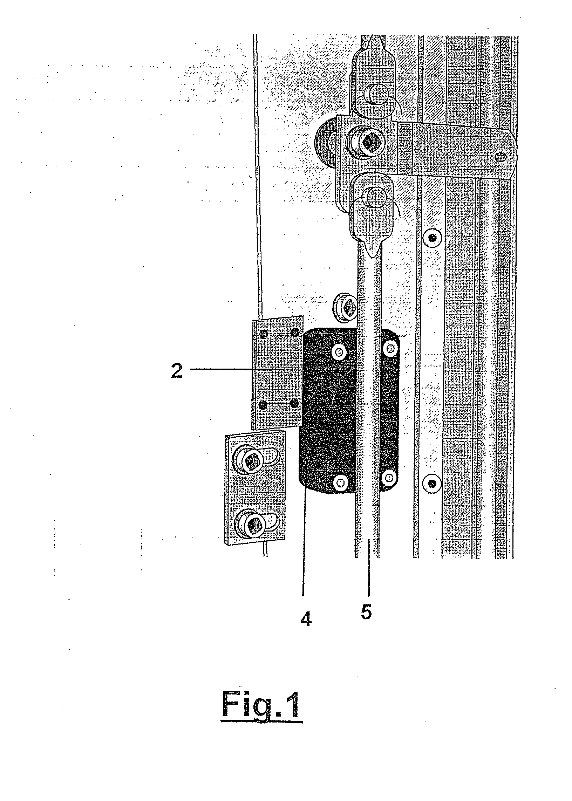

Figure 1 is a detailed front view of the cabinet door inner side showing the micro-cast type lock as a safety device introduced in cabinets to house telecommunication equipment.

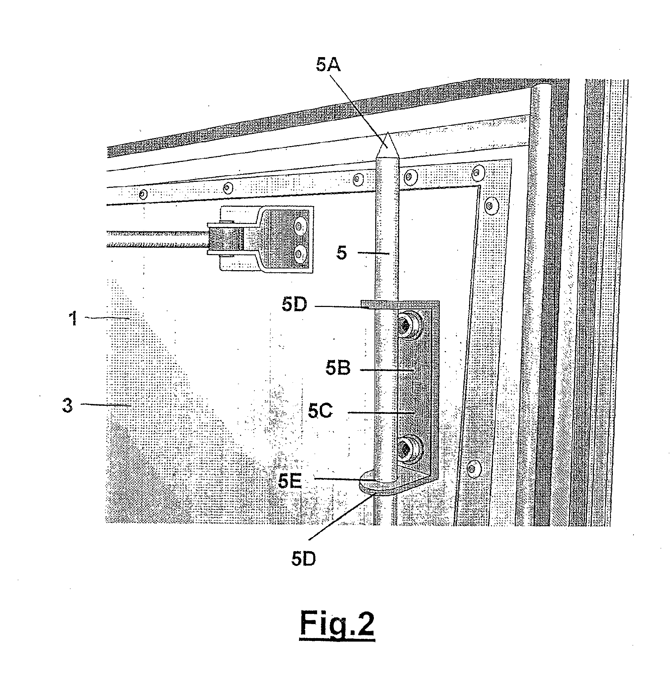

Figure 2 is a detailed front view of the cabinet door inner side showing the differentiated design for the rod assembly as a safety device introduced in cabinets to house telecommunication equipment.

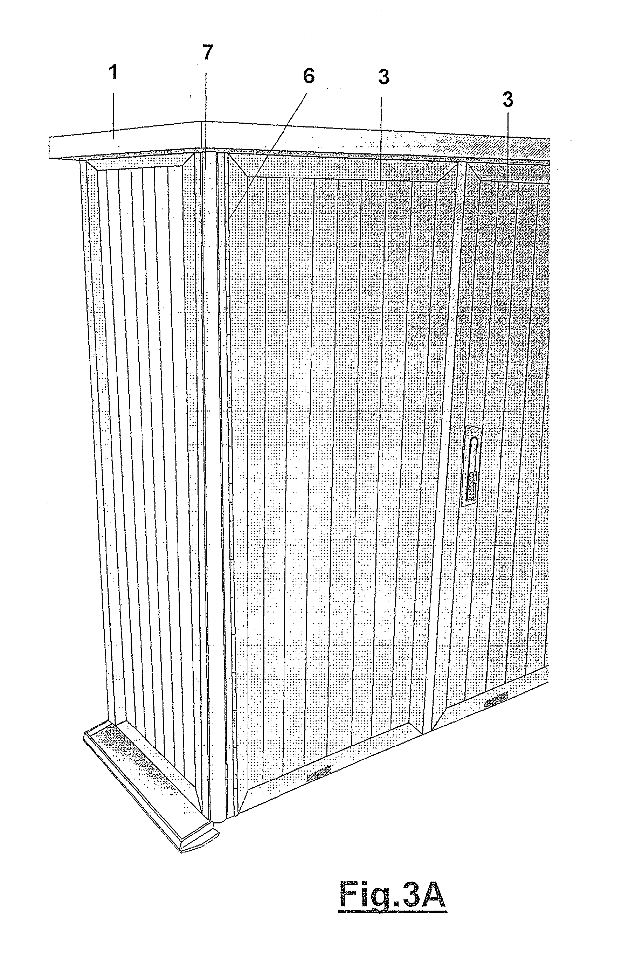

Figure 3A is a front view of the cabinet showing the one-piece hinge as a safety device introduced in cabinets to house telecommunication equipment.

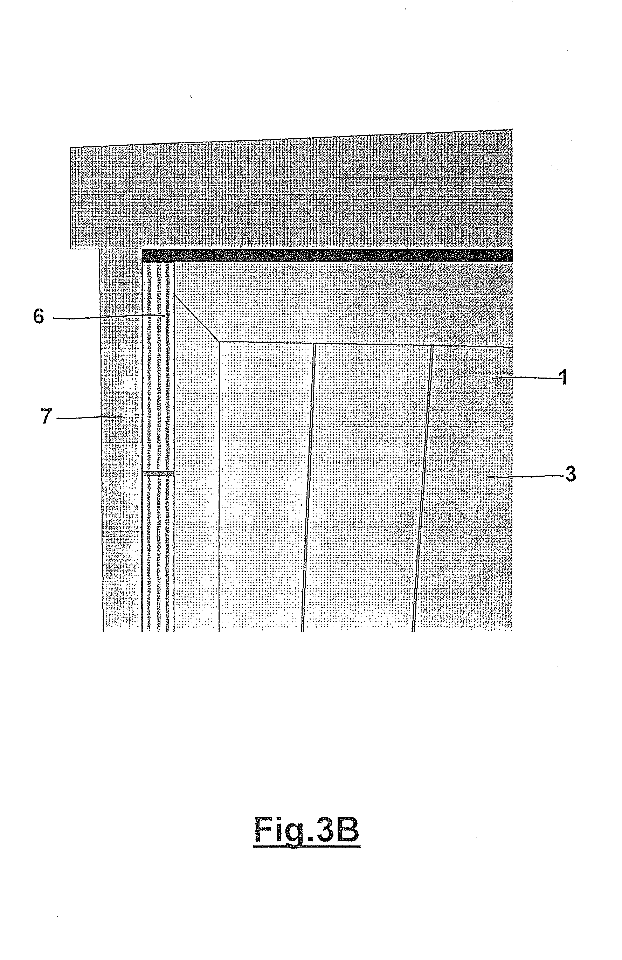

Figure 3B is a detailed front view of the cabinet showing the one-piece hinge as a safety device introduced in cabinets to house telecommunication equipment.

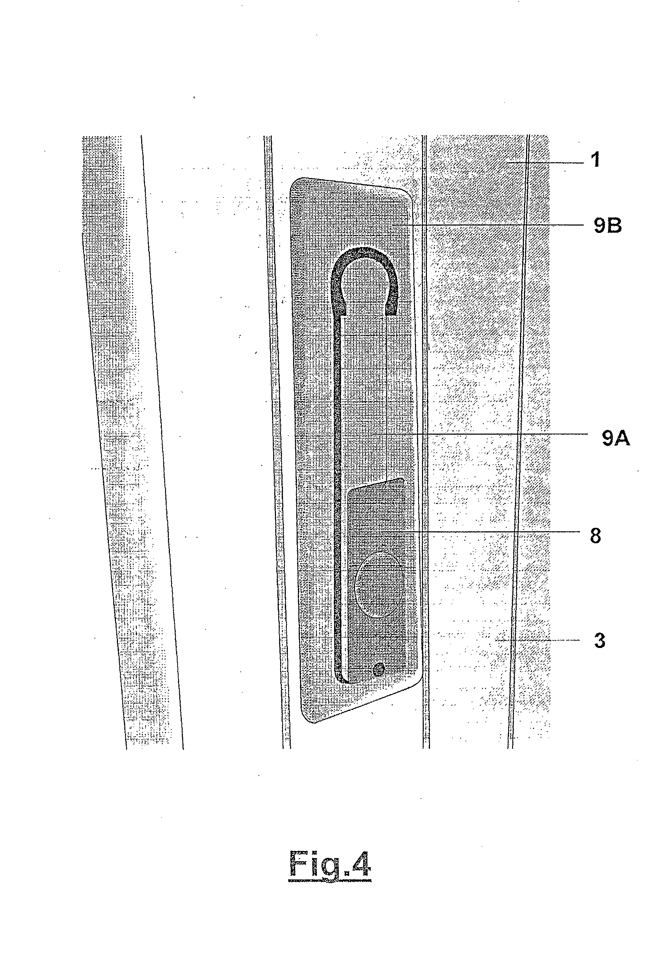

Figure 4 is a detailed front view of the cabinet showing the micro-cast type lock as a safety device introduced in cabinets to house telecommunication equipment.

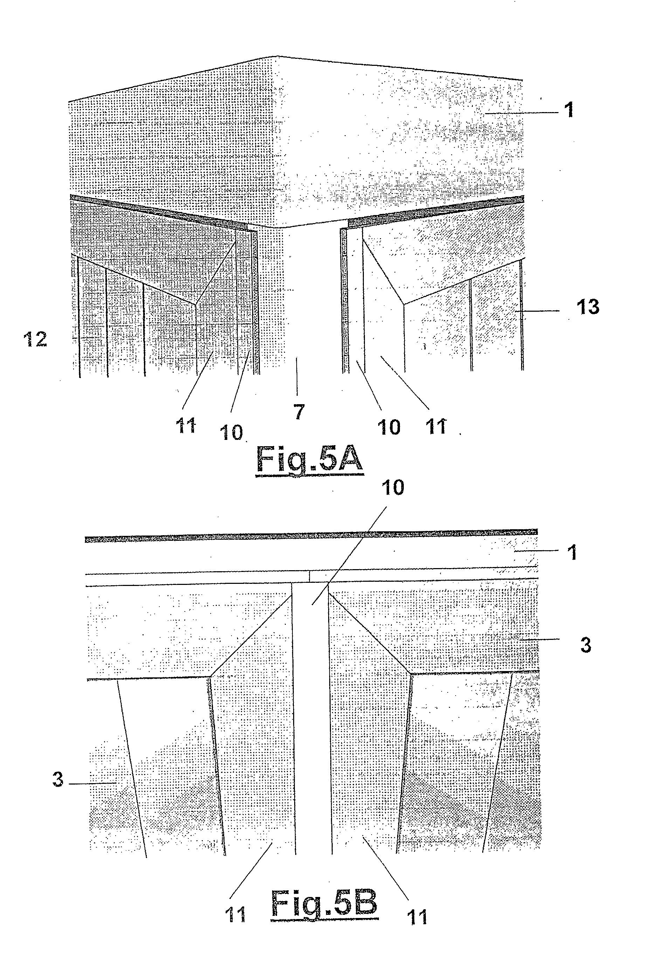

Figure 5A is a detailed side view of the cabinet showing the vertical profiles for the closing frames provided with protective borders as a safety device introduced in cabinets to house telecommunication equipment.
Figure 5B is a detailed front view of the cabinet showing the vertical profiles for the closing frames provided with protective borders as a safety device introduced in cabinets to house telecommunication equipment.

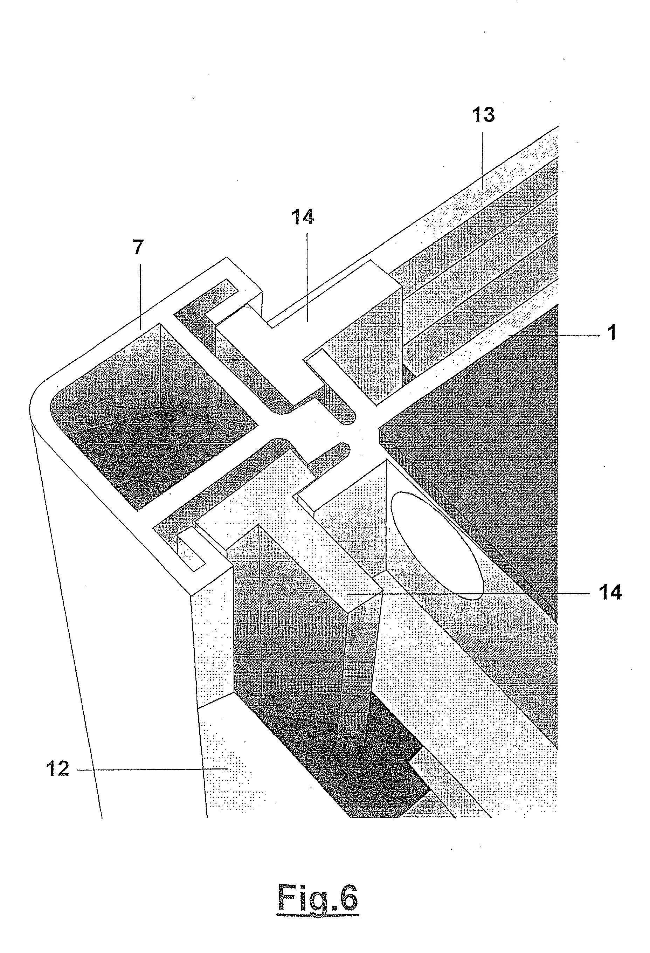

Figure 6 is a detailed top view of the cabinet without the top cover showing the T-profiles as a safety device introduced in cabinets to house telecommunication equipment.

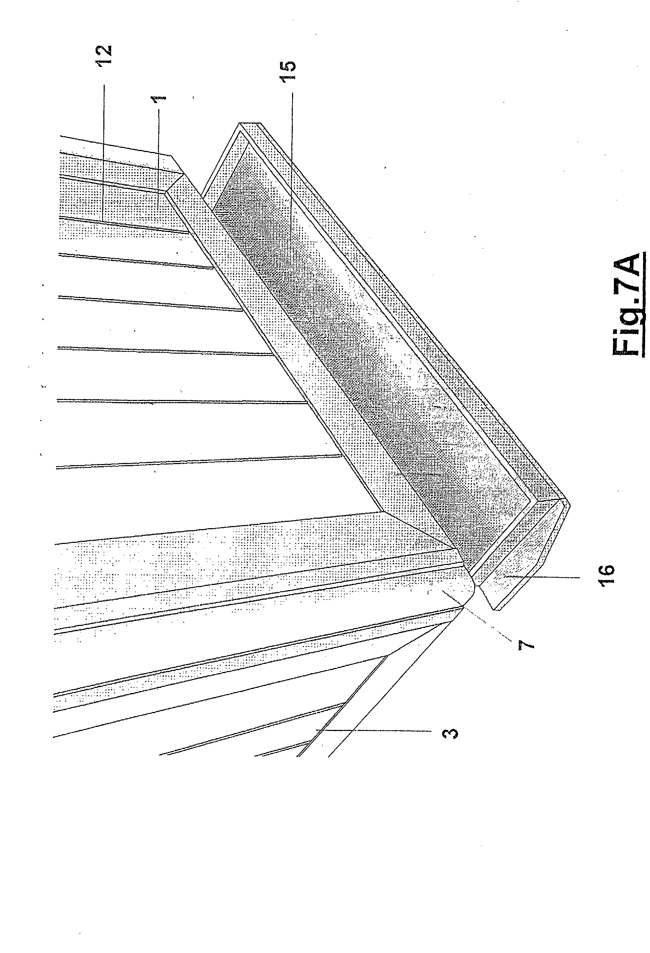

Figure 7A is a detailed side view of the cabinet showing the protection device for the outer anchor shoe bolts as a safety device introduced in cabinets to house telecommunication equipment.

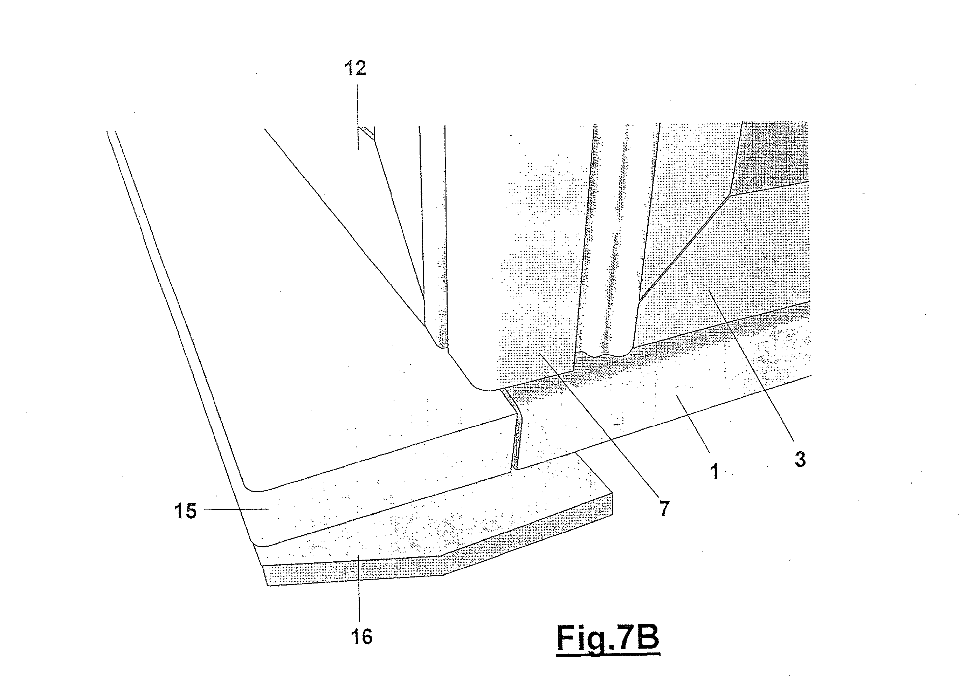

Figure 7B is a detailed front view of the cabinet showing the protection device for the outer anchor shoe bolts as a safety device introduced in cabinets to house telecommunication equipment.

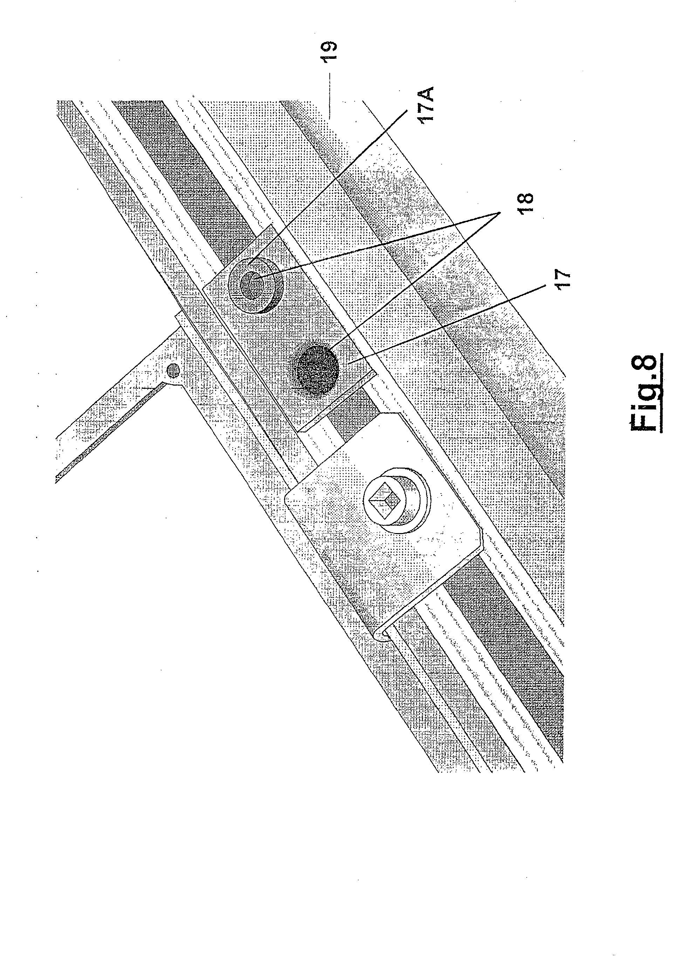

Figure 8 is a detailed top view of the cabinet inner side showing the device for housing the door rod tips as a safety device introduced in cabinets to house telecommunication equipment.

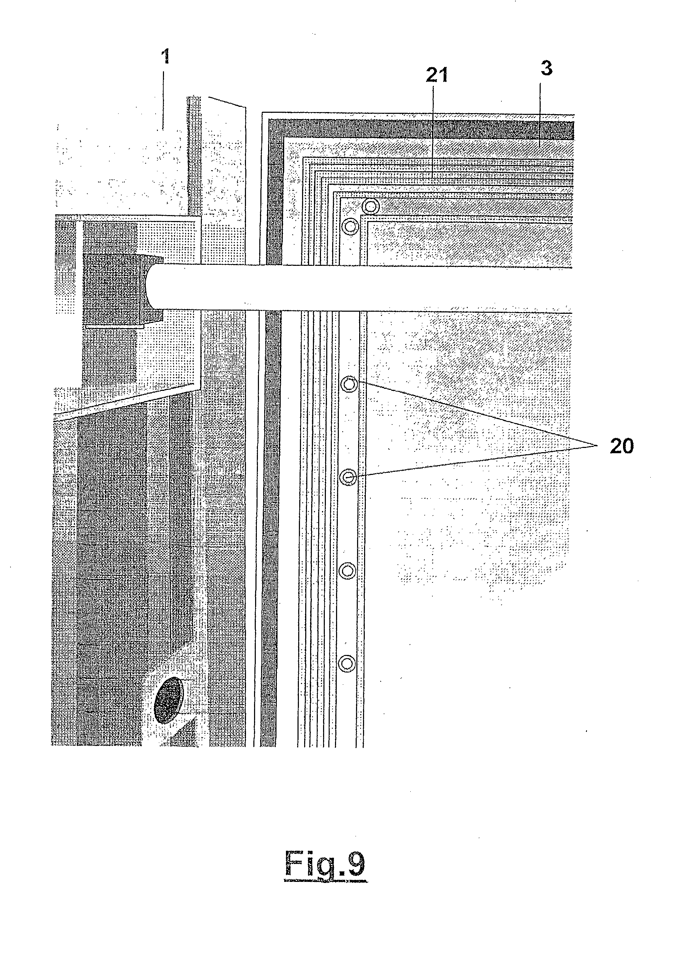

Figure 9 is a detailed front view of the cabinet door inner side showing the set of rivets as a safety device introduced in cabinets to house telecommunication equipment.

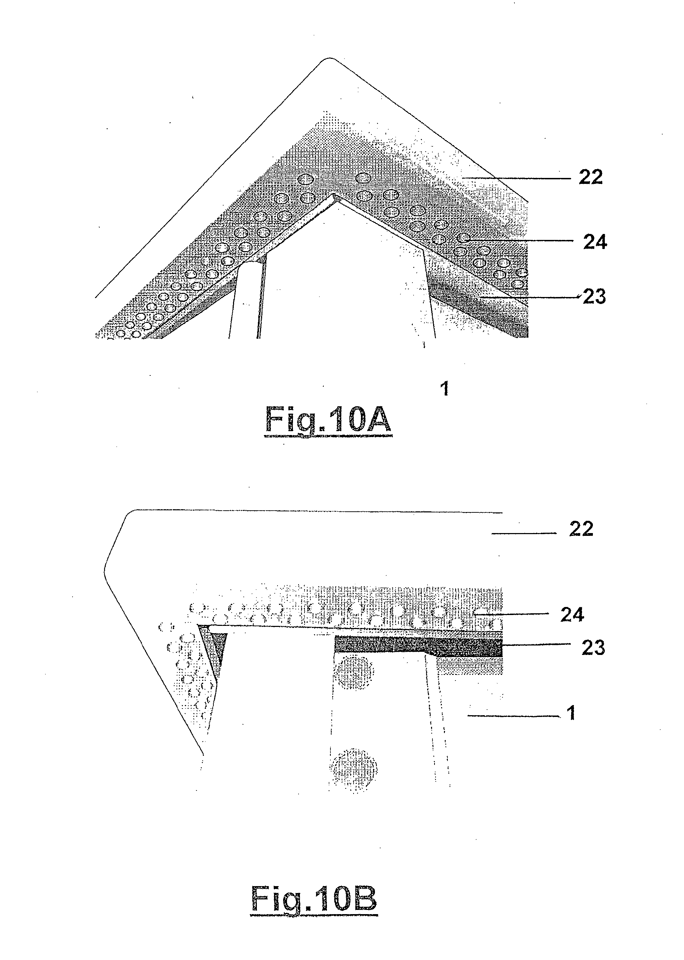

Figure 10A is a detailed lower view of the cabinet cover showing the additional rim of the hood as a safety device introduced in cabinets to house telecommunication equipment.
Figure 10B is a further detailed lower view of the cabinet cover showing the additional rim of the hood as a safety device introduced in cabinets to house telecommunication equipment.

As can be inferred from the appended drawings that illustrate and integrate the present descriptive report of the patent for utility model of "Safety devices introduced in cabinets to house telecommunication equipment", the appended figures show the same in a general manner, possessing a set of devices and improvements in the safety area comprising and improving various proper and specific components made of metallic material or similar material having equal or higher lightness and strength properly arranged (fitted and attached) to the basis structure of the cabinet (1) made of double plates of aluminum or similar material with a plate/plate sandwich-type closing system and a double wall to house telecommunication equipment in general, the safety devices comprise a micro-switch type key (2) with an internal alarm properly installed on the inner side of the door (3), and centered to its clear lateral end, the operation of which is carried out when the lock (4) is fully closed and locked and the alarm sets off when the lock (4) is not fully closed and locked as shown in figure (1); a differentiated design for the rod assembly (5) on the doors (3) of cabinet (1) properly arranged on the inner side thereof and containing a rod (5) with a pointed tip (5A) so as to allow a larger support area for the rod (5), two rod guides (5B) in a single module, one of them attached near the clear top side end of the door and the other attached near the clear lower side end of the door (3), both vertically aligned and each with a rectangular base plate (5C) and two guide points (5D), one on each side of the base plate ends (5C) with a centered hole (5E) for the rod (5) passage so as to allow the entire assembly greater strength, and an inner support made by a stainless steel rectangular shaped attachment plate attached to the door inner side (3) at the rod guides (5B) rear alignment, as the doors (3) are comprised of a plate/plate sandwich closing system with double walls (inner and outer) to reinforce and provide greater strength to the rod guide (5B) attachment, as shown in figure (2); an one-piece hinge (6), that is, arranged along the entire lateral end of the cabinet door (3) and fastening it to the vertical columns (7) of the support and holding frame thereof to prevent any foreign objects from being inserted between the door (3) and the vertical column (7) to break them open, as shown in figures (3A) and (3B); micro-cast type lock (8) with a compact and strong shape in micro-cast stainless steel of excellent mechanical strength arranged on the front side of the door (3) of cabinet (1) near the clear lateral side thereof and bolted to the inner side, also containing a handle (9A) and a frame (9B) to prevent tools or any other objects from being used to crack it open, as shown in figure (4); protective borders (10) of generally rectangular shapes and average width properly arranged over the lateral ends of the vertical profiles for the door closing frames (11), over the lateral plates (12) and over the rear plates (13) of cabinet (1) so as to eliminate any gaps between the vertical columns (7) and the vertical profiles of the closing frames (11), the protective borders (10) being also inserted between the two front doors (3), as shown in figures (5A) and (5B); T-profiles (14) properly arranged lengthwise on the inner periphery of the vertical columns (7) and slightly projected on the doors (3), on the lateral plates (12), and on the rear plates (13) so as to form a reinforcement between them and prevent the closing frames thereof from being removed even if all the fastening bolts are removed, as shown in figure (6); a lower protection device (15) of generally parallelepipedal shape and hollow on its lower face properly attached to the lower lateral faces of the cabinet, more specifically along the alignment of the bolts for the outer anchor shoe (16) of cabinet (1) fastening it to a cement base or other type of base completely exposed to and subjected to vandalism, so as the lower protection device (15) can protect and completely conceal those bolts, as shown in figures (7A) and (7B); two devices for housing the rod tips (17) both made of stainless steel or similar material of generally rectangular shape with two symmetrically centered holes (18), one for attachment by means of a bolt (17A) and the other for the insertion and housing of the rod tip (5A), both holes being perfectly and centrally attached to the upper and lower horizontal columns (19) of the support and holding frame of the front portion of cabinet (1) on the same alignment of the rod (5), working as a lock thereof and leading the rod tips (5A) to be safely and efficiently housed into them and into the horizontal columns (19), as shown in figure (8); a set of rivets (20) with an enlarged number of rivets symmetrically arranged along the inner periphery of the doors (3) of cabinet (1), more specifically along the profile (21) lodging the hinge (6) with an enlarged number of attachment rivets for the doorframe profile (21), so as to improve the mechanical strength of the door (3) thus making it more difficult to remove thereof as shown in figure (9); and an additional rim (22) of generally parallelepipedal shape and rounded edges properly arranged on the periphery of the hood (23) of cabinet (1) as an extension thereof and possessing a set of openings (24) of circular shape symmetrically arranged along its lower face to avoid the insertion of objects or tools that might be used as a lever to crack it open, as shown in figures (10A) and (10B).

The majority of the safety devices introduced in cabinets to house telecommunication equipment are based on the utilization of devices and improvements directly applied to the support and holding frame of the cabinet (1), with the purpose of reinforcing its structure and of the components thereof, mainly against the insertion of objects and/or tools in general intended to overcome the cabinet (1) inviolability.

The safety devices introduced in cabinets to house telecommunication equipment, as based on their general concepts, possess separate operations, aiming at guaranteeing the total integrity and safety of the cabinets (1) and the electronic equipment contained thereof, as shown on the appended figures. Those safety devices have been designed to provide full safety against the cabinet (1) violation; their principles comprising both access and security aspects without prejudice to their general characteristics.

The components of the safety devices introduced in cabinets to house telecommunication equipment are fully fitted and attached, are quickly installed, do not present any distorting or breakable parts, are highly resistant and completely safe. After fitted and attached to the structure of the cabinet (1), the components are locked and attached, thus preventing them from getting loose or breaking when in use.

As their structures are made of metallic material or similar material with equal or higher lightness and strength, the safety devices introduced in cabinets to house telecommunication equipment and the components and accessories thereof, are rustproof and waterproof, have a high level of durability and strength, provide great safety and, when used in the cabinets (1), do not present any risks of fatigue or of being vulnerable to acts of vandalism and non authorized access.

For all of the above, this is an invention that will be well received by the companies employing cabinets to house telecommunication equipment in general, since the present safety devices introduced in cabinets to house telecommunication equipment present several advantages, such as: great safety, reliability and agility in its applications and uses; great strength and durability, since this is a high technology product; greater comfort, facility and safety to the users; lower wear of the assembly; accessible costs, which provides an optimum cost/benefit ratio; practical and safe usage by any users; practical and safe maintenance; great mobility and flexibility allowing an easy transportation to any place; modern design; practical and safe assembly and installation; general arrangements that do not upset the cabinet normal operation and take up small room; and the certainty of always having a cabinet (1) to house the most varied telecommunication equipment under optimum conditions of safety and inviolability.

For all of the above, the safety devices introduced in cabinets to house telecommunication equipment can be classified as a fully versatile, efficient, practical and safe set of means for companies making use of cabinets to house telecommunication equipment in general against vandalism, theft, robberies, non authorized access and the like, in any public place, such as at the base of antennas, or public ways and installations in general, regardless of the general characteristics thereof; they are also easy to install and to handle, and have great strength and excellent characteristics; the sizes and dimensions may vary, depending on the use needs.

## Claims

1. SAFETY DEVICES INTRODUCED IN CABINET TO HOUSE TELECOMMUNICATION EQUIPMENT, **characterized in that** it comprises a set of devices and improvements in the safety area comprising and improving various proper and specific components made of metallic material or similar material with equal or higher lightness and strength, properly arranged (fitted and attached) to the basis structure of the cabinet (1), made of double plates of aluminum or similar material with a plate/plate sandwich-type closing system and double walls to house telecommunication equipment in general.

2. SAFETY DEVICES, in accordance with claim 1, **characterized in that** it contains a micro-switch type key (2) with an internal alarm properly installed on the inner side of the door (3), and centered to its clear lateral end, the operation of which is carried out when the lock (4) is fully closed and locked and the alarm sets off when the lock (4) is not fully closed and locked.

3. SAFETY DEVICES, in accordance with claim 1, **characterized in that** it comprises a differentiated design for the door rod assembly (5) of cabinet (1) arranged on the door inner side (3) and containing a rod (5) with a pointed tip (5A), two rod guides (5B) in a single module, one of them attached near the clear top side end of the door and the other attached near the clear lower side end of the door (3), both vertically aligned and each with a rectangular base plate (5C) and two guide points (5D), one on each end of the base plate (5C) with a centered hole (5E) for the rod (5) passage and an inner support formed by a rectangular shaped attachment plate in stainless steel attached to the door inner side (3) at the guide rod (5B) rear alignment as the doors (3) are double walled.

4. SAFETY DEVICES, in accordance with claim 1, **characterized in that** it contains an one-piece hinge (6), that is, arranged along the entire lateral end of the door (3) of cabinet (1) and fastening it to the vertical columns (7) of the support and holding frame thereof.

5. SAFETY DEVICES, in accordance with claim 1, **characterized in that** it contains a micro-cast type lock (8) with a compact and strong shape in micro-cast stainless steel of excellent mechanical strength arranged on the front portion of the door (3) near the clear lateral side thereof and bolted to the inner side, also containing a handle (9A) and a frame (9B).

6. SAFETY DEVICES, in accordance with claim 1, **characterized in that** it contains protective borders (10) of generally rectangular shapes and average width properly arranged over the lateral ends of the vertical profiles for the door closing frames (11), over the lateral plates (12) and over the rear plates (13) of cabinet (1) so as to eliminate any gaps between the vertical columns (7) and the vertical profiles for the closing frames (11); the protective borders (10) being also inserted between the two front doors (3).

7. SAFETY DEVICES, in accordance with claim 1, **characterized in that** it contains T-profiles (14) arranged lengthwise on the inner periphery of the vertical columns (7) and slightly projected on the doors (3), on the lateral plates (12) and on the rear plates (13) so as to form a reinforcement between them.

8. SAFETY DEVICES, in accordance with claim 1, **characterized in that** it contains a lower protection device (15) having a generally parallelepipedal shape and hollow on its lower face properly attached to the lower lateral faces of the cabinet, more specifically along the alignment of the bolts for the outer anchor shoe (16) of cabinet (1) fastening it to a cement base or other type of base completely exposed to and subjected to vandalism.

9. SAFETY DEVICES, in accordance with claim 1, **characterized in that** it contains two devices for housing the rod tips (17) both made of stainless steel or similar material having a generally rectangular shape with two symmetrically centered holes (18), one for attachment by means of a bolt (17A) and the other for the insertion and housing of the rod tip (5A), both holes centrally attached to the upper and lower horizontal columns (19) of the support and holding frame of the front portion of cabinet (1) on the same alignment of the rod (5).

10. SAFETY DEVICES, in accordance with claim 1, **characterized in that** it contains a set of rivets (20) with an enlarged number of rivets symmetrically arranged on the inner periphery of the doors (3), more specifically along the profile (21) lodging the hinge (6) with an enlarged number of attachment rivets for the doorframe profile (21).

11. SAFETY DEVICES, in accordance with claim 1, **characterized in that** it contains an additional rim (22) having a generally parallelepipedal shape and rounded edges properly arranged on the periphery of the hood (23) of the cabinet (1) as an extension thereof and having a set of openings (24) of circular shape symmetrically arranged along its lower face.
